# EUROPEAN PATENT APPLICATION

(11) **EP 4 496 447 A1**
(43) Date of publication of application: **22.01.2025**
(21) Application number: 23914196.3
(22) Date of filing: 15.05.2023
(51) Int. Cl.: H10B 12/00

(54) **SEMICONDUCTOR STRUCTURE AND MANUFACTURING METHOD THEREFOR**

(30) Priority: 04.01.2023 CN 202310008468
(71) Applicant: CXMT Corporation, Hefei, Anhui 230601 (CN)
(72) Inventor: HUANG, Meng, Hefei, Anhui 230601 (CN)
(74) Representative: Gulde & Partner
(86) International application number: PCT/CN2023/094326
(87) International publication number: WO 2024/146047

(57) **Abstract**

Embodiments of the present disclosure provide a semiconductor structure and a method for manufacturing the same. The semiconductor structure includes: a plurality of active areas, each one of the plurality of active areas having a first end portion and a second end portion opposite to each other along a third direction, where the second end portion has a first part and a second part extending along the third direction and a third part connecting one end of the first part and one end of the second part, the third part is located at one end close to the first end portion, and the other end of the first part and the other end of the second part are separated from each other; a plurality of bit lines extending along a second direction and each connected to a plurality of active areas in the same layer; a plurality of word lines extending along a first direction and each connected to a plurality of active areas in the same column; and a plurality of memory structures, each one of the plurality of memory structures covering part of a surface of the second end portion and filling a gap between the first part and the second part.

## Description

### CROSS-REFERENCE TO RELATED APPLICATIONS

The present disclosure is presented based on and claims priority to Chinese Patent Application No. 202310008468.4 filed on Jan. 04, 2023, and entitled "SEMICONDUCTOR STRUCTURE AND METHOD FOR MANUFACTURING SAME", the content of which is incorporated herein in its entirety for reference.

### TECHNICAL FIELD

The present disclosure relates to the technical field of semiconductors and relates to, but is not limited to, a semiconductor structure and a method for manufacturing the same.

### BACKGROUND

Dynamic random access memories (DRAMs) are widely used in mobile phones, tablet computers, and other electronic devices due to their advantages of small size, high integration degree, fast transmission speed, and the like.

With the rapid increase in the popularity of electronic devices and the vigorous development of the electronic device market, electronic products are increasingly required to be miniaturized and thinned while having high performance, multiple functions, high reliability, and convenience. Such demands place higher requirements on the integration degree and reliability of the dynamic random access memories.

### SUMMARY

Embodiments of the present disclosure present a semiconductor structure and a method for manufacturing the same.

In a first aspect, embodiments of the present disclosure provide a semiconductor structure, which includes:
a plurality of active areas forming an array having a plurality of layers arranged along a first direction and a plurality of columns arranged along a second direction, where each one of the plurality of active areas has a first end portion and a second end portion opposite to each other along a third direction; the second end portion has a first part and a second part extending along the third direction and a third part connecting one end of the first part and one end of the second part, and the third part is located at one end close to the first end portion; the other end of the first part and the other end of the second part are separated from each other; every two of the first direction, the second direction, and the third direction intersect with each other;
a plurality of bit lines stacked along the first direction, each one of the plurality of bit lines extending along the second direction and being connected to the first end portions of a plurality of active areas in the same layer;
a plurality of word lines, each one of the plurality of word lines extending along the first direction and being connected to a plurality of active areas in the same column; and
a plurality of memory structures, each one of the plurality of memory structures covering part of a surface of the second end portion and filling a gap between the first part and the second part.

In the above solution, the plurality of memory structures include: a plurality of first electrodes, a dielectric layer, and a second electrode;
each one of the plurality of first electrodes covers part of surfaces of the first part, the second part, and the third part of the second end portion of the active area;
the second electrode is located between the first parts and the second parts of a plurality of active areas in the same column and between the second end portions of two adjacent active areas along the first direction;
the dielectric layer is located between the plurality of first electrodes and the second electrode, and the dielectric layer and the second electrode are shared by a plurality of memory structures in the same column.

In the above solution, sizes of the first part and the second part along the second direction are less than or equal to a size of the third part along the third direction.

In the above solution, a size of the first end portion of the active area along the third direction is less than or equal to a size of the second end portion of the active area along the third direction.

In the above solution, the first part, the second part, and the third part of the second end portion include a metal-semiconductor compound.

In the above solution, the semiconductor structure further includes a plurality of isolation layers, where each one of the plurality of isolation layers is located between two adjacent columns of active areas along the second direction.

In the above solution, each one of the plurality of word lines is connected to a position between the first end portion and the second end portion of each one of a plurality of active areas in the same column, and the plurality of active areas cover two sidewalls of the word line opposite to each other along the second direction and two sidewalls of the word line opposite to each other along the third direction.

In the above solution, a size of each one of the plurality of bit lines along the first direction is equal to a size of the active area along the first direction.
In the above solution, the bit lines are integrally formed with a structure used to form the active areas.

In a second aspect, embodiments of the present disclosure provide a method for manufacturing a semiconductor structure, which includes:
forming a plurality of active areas, where the plurality of active areas form an array having a plurality of layers arranged along a first direction and a plurality of columns arranged along a second direction; each one of the plurality of active areas has a first end portion and a second end portion opposite to each other along a third direction; a first part and a second part extending along the third direction and a third part connecting the first part and the second part are formed at the second end portion, and the third part is located at one end close to the first end portion; every two of the first direction, the second direction, and the third direction intersect with each other;
forming a plurality of bit lines, where the plurality of bit lines are stacked along the first direction, and each one of the plurality of bit lines extends along the second direction and is connected to the first end portions of a plurality of active areas in the same layer;
forming a plurality of word lines, where each one of the plurality of word lines extends along the first direction and is connected to a plurality of active areas in the same column; and
forming a plurality of memory structures, where each one of the plurality of memory structures covers part of a surface of the second end portion and fills a gap between the first part and the second part.

In the above solution, a method for forming the bit lines and the active areas includes:
forming a stack structure along the first direction, where the stack structure includes a plurality of alternately stacked first semiconductor material layers and second semiconductor material layers; and
forming a plurality of first trenches penetrating through the stack structure and extending along the third direction in the stack structure, where the plurality of first trenches divide remaining stack structure into a first stack wall extending along the second direction and a plurality of second stack walls extending along the third direction.

In the above solution, the method further includes:
filling the first trenches with a support layer;
the method for forming the active areas further includes:
   forming a second trench having an open end face at an end portion of each one of the plurality of second stack walls away from the first stack wall along the third direction, where the second trench divides remaining first semiconductor material layers in a part of the second stack wall away from the first stack wall into first parts and second parts extending along the third direction and third parts each connecting one end of the first part and one end of the second part.

In the above solution, an etching selectivity between any two of the support layer, the first semiconductor material layer, and the second semiconductor material layer is greater than 10:1.

In the above solution, the method includes:
removing remaining second semiconductor material layers through the second trench to expose a surface of part of the support layer.

In the above solution, the method includes: filling with a first insulating layer after the remaining second semiconductor material layers are removed; and removing the first insulating layer covering the support layer and surfaces of remaining first semiconductor material layers to expose the surfaces of the remaining first semiconductor material layers and the surface of part of the support layer.

In the above solution, a method for forming the plurality of memory structures includes:
forming an electrode material layer, where the electrode material layer covers exposed surfaces of the first parts, the second parts, and the third parts, and a surface of an exposed part of the support layer;
forming a dielectric layer covering a surface of the electrode material layer;
forming a second electrode covering a surface of the dielectric layer;
removing the support layer;
removing at least part of the first insulating layer close to the electrode material layer; and
removing exposed electrode material layer and forming first electrodes using remaining electrode material layer.

In the above solution, the method further includes:
after the electrode material layer covering the support layer is removed, filling with a second insulating layer at positions where the support layer and the electrode material layer are removed.

In the above solution, forming the word lines includes:
forming a third trench penetrating through the second stack wall at a position close to the first stack wall, where sidewalls of the third trench all expose part of the first semiconductor material layers; and
forming the word line in the third trench.

### BRIEF DESCRIPTION OF THE DRAWINGS

FIG. 1 is a schematic view of a semiconductor structure provided according to an embodiment of the present disclosure;
FIG. 2 is a schematic view of another semiconductor structure provided according to an embodiment of the present disclosure;
FIG. 3 is a schematic view of yet another semiconductor structure provided according to an embodiment of the present disclosure;
FIG. 4 is a schematic flow chart illustrating a method for manufacturing a semiconductor structure provided according to an embodiment of the present disclosure;
FIGS. 5-14 are schematic structural views illustrating a manufacturing process of a semiconductor structure provided according to an embodiment of the present disclosure;
FIG. 15 is a cross-sectional view of a memory structure of a semiconductor structure provided according to an embodiment of the present disclosure.

### DETAILED DESCRIPTION

Exemplary embodiments of the present disclosure will be described in more detail below with reference to the drawings. While exemplary embodiments of the present disclosure are shown in the drawings, it should be understood that the present disclosure may be implemented in various forms and should not be limited by the specific embodiments set forth herein. Rather, these embodiments are provided so that the present disclosure will be more thoroughly understood and the scope of the present disclosure will be fully conveyed to those skilled in the art.

In the following description, numerous specific details are set forth in order to provide a more thorough understanding of the present disclosure. However, it is apparent to those skilled in the art that the present disclosure can be implemented without one or more of these details. In other instances, some well-known technical features in the art are not described to avoid confusion with the present disclosure; i.e., not all features of the actual embodiments are described herein, and well-known functions and structures are not described in detail.

In the drawings, the sizes of layers, regions, and elements, and their relative sizes may be exaggerated for clarity. Identical reference numerals represent identical elements throughout the text.

It should be appreciated that when an element or a layer is referred to as being "on", "adjacent to", "connected to", or "coupled to" another element or layer, it may be directly on, adjacent to, connected to, or coupled to the another element or layer, or an intervening element or layer may be present. On the contrary, when an element is referred to as being "directly on", "directly adjacent to", "directly connected to", or "directly coupled to" another element or layer, no intervening element or layer is present. It should be appreciated that, although the terms first, second, third, etc., may be used to describe various elements, components, regions, layers, and/or parts, the elements, components, regions, layers, and/or parts should not be limited by these terms. These terms are only used to distinguish one element, component, region, layer, or part from another element, component, region, layer, or part. Therefore, a first element, component, region, layer, or part discussed below may be termed a second element, component, region, layer, or part without departing from the teachings of the present disclosure. However, the discussion of a second element, component, region, layer, or part does not necessarily imply that a first element, component, region, layer, or part is necessarily present in the present disclosure.

Spatial relationship terms, e.g., "under", "below", "underneath", "beneath", "on", "above", and the like, may be used herein for ease of description to describe the relationship between an element or a feature shown in the figures and other elements or features. It should be appreciated that the spatial relationship terms are intended to encompass different orientations of the device in use or operation in addition to the orientations depicted in the figures. For example, if the device in the figures is turned over, elements or features described as being "below", "beneath", or "under" other elements or features would then be oriented "above" the other elements or features. Therefore, the exemplary terms "below" and "under" may include both up and down orientations. A device may be otherwise oriented (rotated 90 degrees or at other orientations) and the spatial descriptors used herein may be interpreted accordingly.

The terms used herein are for the purpose of describing specific embodiments only and should not be construed as limiting the present disclosure. As used herein, the singular forms "a", "an", and "the" are intended to include the plural forms as well, unless the context clearly indicates otherwise. It should be further appreciated that the terms "comprise" and/or "include", when used in this specification, specify the presence of stated features, integers, steps, operations, elements, and/or components, but do not preclude the presence or addition of one or more other features, integers, steps, operations, elements, components, and/or groups. As used herein, the term "and/or" includes any and all combinations of the associated listed items.

To have a more detailed understanding of the characteristics and technical content of the embodiments of the present disclosure, the implementation of the embodiments of the present disclosure is described in detail in combination with the drawings. The attached drawings are for the purposes of reference and explanation only and are not used to limit the embodiments of the present disclosure.

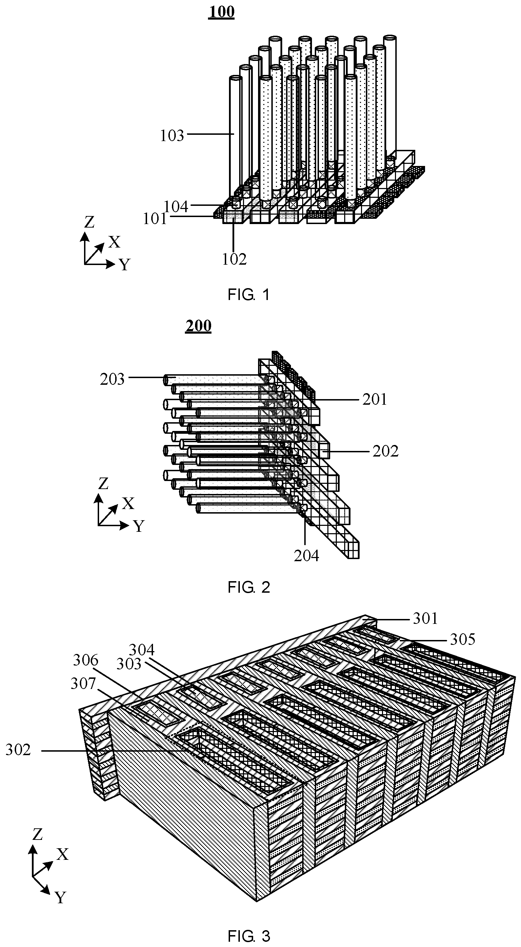

With the development of dynamic random access memory technology, the size of the memory cell is increasingly small, and the memory cell is becoming three-dimensional to achieve a higher storage density. FIG. 1 is a schematic view of a semiconductor structure provided according to an embodiment of the present disclosure. As shown in FIG. 1, the semiconductor structure includes a memory array 100. The memory array 100 includes a plurality of memory cells, bit lines 101, and word lines 102, and each memory cell includes a transistor 104 and a capacitor 103 connected to one end of a source or a drain of the transistor 104. As the requirements on the performance of the dynamic random access memory increase, the charge stored in the capacitor 103 is required to be larger and larger. According to FIG. 1, the transistors 104 are arranged in an array on a horizontal plane, that is, a plane where an X axis and a Y axis shown in FIG. 1 are located. In the case that a density of the transistor 104 is not changed, to increase a charge storage of the capacitor 103, the most direct way is to continue to extend a length of the capacitor 103 in an extension direction thereof, that is, the length of the capacitor 103 in a Z axis direction shown in FIG. 1 is increased to increase the charge storage of the capacitor. Increasing the length in the Z axis direction means that a deeper through hole needs to be obtained by etching when the capacitor is manufactured. High process difficulties are present in obtaining a deeper through hole during manufacturing. In one aspect, the collapse of the through hole is easily caused; in another aspect, it is difficult to maintain the consistency of the through hole. It can be understood that the size of the cross section close to the bottom of the through hole is smaller than the cross section of the top of the through hole, so that the consistency of the top and bottom of the through hole is difficult to maintain.

Based on this, the embodiments of the present disclosure provide a concept of turning over the semiconductor structure, and FIG. 2 is a schematic view of another semiconductor structure provided according to an embodiment of the present disclosure. As shown in FIG. 2, the semiconductor structure includes a memory array 200. The memory array 200 includes a plurality of memory cells, bit lines 201, and word lines 202, and each memory cell includes a transistor 204 and a capacitor 203 connected to one end of a source or a drain of the transistor 204. According to FIG. 2, the transistor 204 in the memory cell and the capacitor 203 connected to the transistor are on the same horizontal plane, that is, a plane defined by an X axis and a Y axis shown in FIG. 2, and a plurality of memory cells are arranged in a certain direction on the horizontal plane. As shown in FIG. 2, a plurality of memory cells are arranged in an X axis direction and stacked in multiple layers in a Z axis direction, and at this moment, the capacitors 203 in the memory cells extend along a Y axis direction. In the case that a density of the transistors 204 is not changed, to increase a charge storage of the capacitor 203, the most direct way is to continue to extend a length of the capacitor 103 in an extension direction thereof, and at the moment, the extension direction thereof is the Y axis direction. Compared with increasing the length of the capacitor in the Z axis direction, increasing the length of the capacitor in the Y axis direction can avoid etching for a deeper through hole, and only increasing the size of the horizontal transverse etching is needed. While increasing the charge storage of the capacitor, the shape of the capacitor can be effectively maintained and the difficulty of the manufacturing process can be reduced.

FIG. 3 is a schematic view of yet another semiconductor structure provided according to an embodiment of the present disclosure. In FIG. 3, the semiconductor structure includes a plurality of bit lines 301 stacked in the Z axis direction. Each bit line 301 extends along the X axis direction and is connected to first end portions 306 of a plurality of transistors in the same layer; each word line 303 extends along the Z axis direction, a channel 307 of the transistor surrounds the word line 303 to form a channel all around (CAA) structure, and a gate dielectric layer 304 is further included between the word line 303 and the channel 307; each capacitor 302 is connected to a second end portion 305 of a corresponding transistor, the first end portion 306 is one of a source or a drain of the transistor, and the second end portion 305 is the remaining one of the source or the drain of the transistor. The method for forming a capacitor 302 on the horizontal plane (i.e., the plane where the X axis and the Y axis are located) is as follows: forming a closed trench in an active area (AA) and then forming a capacitor in the trench. The capacitor 302 shown in FIG. 3 only shows one polar plate of the capacitor, and neither the dielectric layer nor the other polar plate of the capacitor is shown.

It can be understood that, in the above solution, the process of forming the closed trench is relatively complicated; meanwhile, a deposition process such as ALD is required for forming electrode plates and dielectric layer of the capacitor subsequently, and the closed trench is not beneficial for forming inlet and outlet channels of ALD gas, so that the difficulty of the subsequent process is increased.

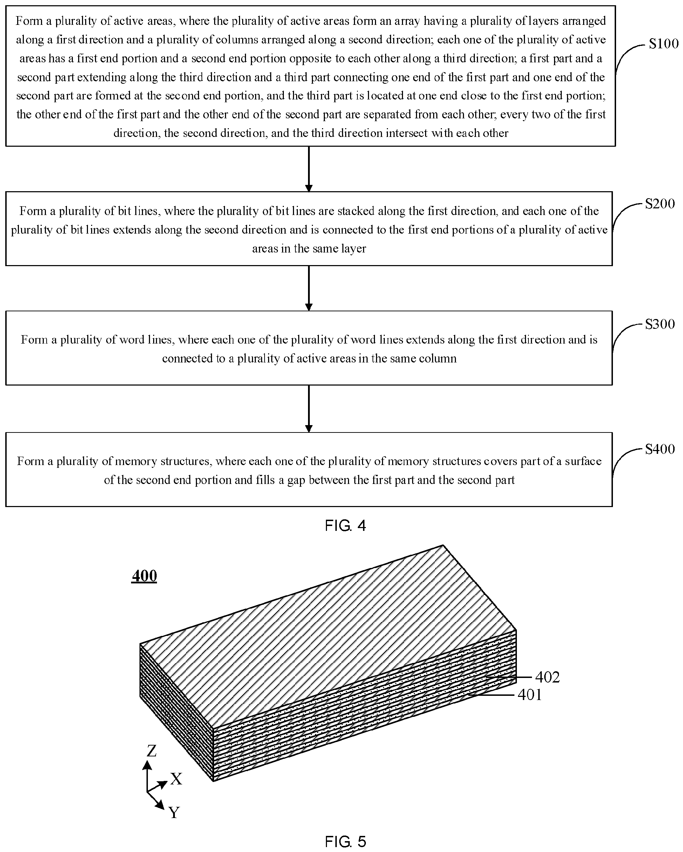

Based on this, to solve one or more of the above problems, the embodiments of the present disclosure provide a method for manufacturing a semiconductor structure. FIG. 4 is a schematic flow chart illustrating a method for manufacturing a semiconductor structure provided according to an embodiment of the present disclosure. As shown in FIG. 4, the method for manufacturing a semiconductor structure provided according to an embodiment of the present disclosure includes the following steps:
S100: forming a plurality of active areas, where the plurality of active areas form an array having a plurality of layers arranged along a first direction and a plurality of columns arranged along a second direction; each one of the plurality of active areas has a first end portion and a second end portion opposite to each other along a third direction; a first part and a second part extending along the third direction and a third part connecting one end of the first part and one end of the second part are formed at the second end portion, and the third part is located at one end close to the first end portion; the other end of the first part and the other end of the second part are separated from each other; every two of the first direction, the second direction, and the third direction intersect with each other;
S200: forming a plurality of bit lines, where the plurality of bit lines are stacked along the first direction; each one of the plurality of bit lines extends along the second direction and is connected to the first end portions of a plurality of active areas in the same layer;
S300: forming a plurality of word lines, where each one of the plurality of word lines extends along the first direction and is connected to a plurality of active areas in the same column; and
S400: forming a plurality of memory structures, where each one of the plurality of memory structures covers part of a surface of the second end portion and fills a gap between the first part and the second part.

It should be understood that the steps shown in FIG. 4 are not exclusive and that other steps may be performed before, after, or between any of the steps in the operations shown; the sequence of steps shown in FIG. 4 may be adjusted according to actual requirements. FIGS. 5-14 are schematic cross-sectional views illustrating a manufacturing process of a semiconductor structure provided according to an embodiment of the present disclosure. It should be noted that FIGS. 5-14 are schematic views illustrating a complete implementation process of a method for manufacturing a semiconductor structure, and parts not labeled in some of the figures may be shared with each other. The method for manufacturing a semiconductor structure provided according to an embodiment of the present disclosure is described in detail below with reference to FIGS. 4 and 5-14.

In step S100, a plurality of active areas are mainly formed.

In step S200, a plurality of bit lines are mainly formed.

It should be noted here that the step S100 of mainly forming the active areas and the step S200 of mainly forming the bit lines are not strictly separated, and the bit lines are formed in the process of forming the active areas, and it should be further noted that the active areas and the bit lines are all formed on the substrate.

In some specific embodiments, the substrate may include an elemental semiconductor material substrate (e.g., a silicon (Si) substrate, a germanium (Ge) substrate, etc.), a composite semiconductor material substrate (e.g., a silicon germanium (SiGe) substrate, etc.), a silicon-on-insulator (SOI) substrate, a germanium-on-insulator (GeOl) substrate, etc. In some specific embodiments, the substrate is a silicon substrate.

In some embodiments, a peripheral circuit may be formed on the substrate prior to forming the semiconductor structure.

Here, the memory may include a semiconductor structure and a peripheral circuit. The semiconductor structure includes a memory array structure, where the memory array structure includes a plurality of memory cells, and each memory cell includes an active area and a memory structure; the active area has a first end portion and a second end portion opposite to each other along a third direction, the second end portion has a first part and a second part extending along a third direction and a third part connecting one end of the first part and one end of the second part, the third part is located at one end close to the first end portion, and the other end of the first part and the other end of the second part are separated from each other; the memory structure covers part of a surface of the second end portion and fills a gap between the first part and the second part of the second end portion. The memory cells above form an array having a plurality of layers arranged along a first direction and a plurality of columns arranged along a second direction; the active area in each memory cell extends along a third direction; every two of the first direction, the second direction, and the third direction intersect with each other; the peripheral circuit is connected to the semiconductor structure and is configured to control the memory cells to realize data writing, reading, refreshing, and the like.

In some specific embodiments, the peripheral circuit may include a command decoder, an address buffer, a row address multiplexer, a row decoder, a memory bank control logic, a column address latch, a column decoder, an input/output gating circuit, and a data input/output buffer, and the like. In some specific embodiments, the peripheral circuit may be formed using the metal-oxide-semiconductor (MOS) technology.

It can be understood that in the embodiments of the present disclosure, the peripheral circuit may be directly formed on the substrate, and then the semiconductor structure is formed on the peripheral circuit, so that the peripheral circuit and the memory cell (including the memory structure and the active area) may be directly stacked on one substrate, thereby facilitating three-dimensional integration and size miniaturization of the memory containing the semiconductor structure based on the embodiments of the present disclosure.

In some embodiments, forming the bit lines and the active areas includes:
forming a stack structure along the first direction, where the stack structure includes a plurality of alternately stacked first semiconductor material layers and second semiconductor material layers; and
forming a plurality of first trenches penetrating through the stack structure and extending along the third direction in the stack structure, where the plurality of first trenches divide remaining stack structure into a first stack wall extending along the second direction and a plurality of second stack walls extending along the third direction.

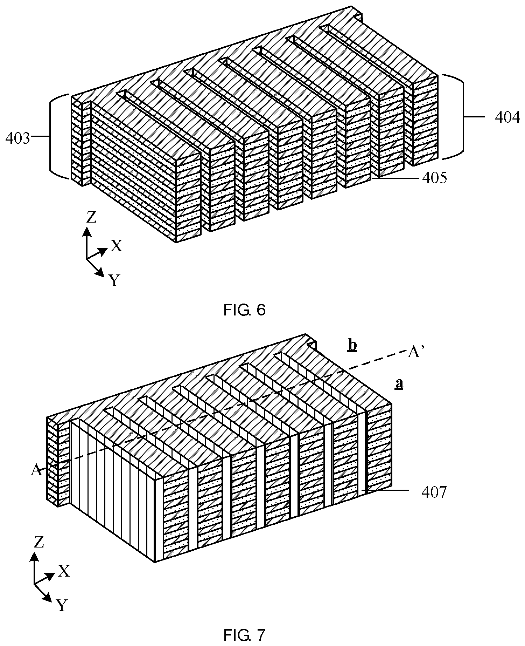

The process of forming the plurality of active areas and the bit lines will be described in detail below with reference to FIGS. 5 and 6.
As shown in FIG. 5, a stack structure 400 is formed on a substrate along a first direction, and the stack structure 400 includes a plurality of alternately stacked first semiconductor material layers 401 and second semiconductor material layers 402.

The substrate is not shown in FIGS. 5-14 to highlight the manufacturing process of the semiconductor structure. The first direction is a direction that may be perpendicular to a surface of the substrate; illustratively, the first direction is a Z axis direction shown in FIGS. 5-14. However, it should be noted that the description in the following embodiments with respect to the directions is only for illustrating the present disclosure and is not intended to limit the scope of the present disclosure.

In some specific embodiments, a constituent material of the first semiconductor material layer 401 includes, but is not limited to, silicon (Si). In some specific embodiments, a method for forming the first semiconductor material layer 401 includes, but is not limited to, an epitaxial process.

In some specific embodiments, a constituent material of the second semiconductor material layer 402 includes, but is not limited to, silicon germanium (SiGe). In some specific embodiments, a method for forming the second semiconductor material layer 402 includes, but is not limited to, an epitaxial process.

In some specific embodiments, the first semiconductor material layer 401 and the second semiconductor material layer 402 may be a superlattice formed by epitaxy. The superlattice is a periodic structure formed by alternately growing two materials with well-matched lattices, and a thickness of each layer of material is less than 100 nm.

Here, a material composition of the second semiconductor material layer 402 is different from that of the first semiconductor material layer 401, and a material of the second semiconductor material layer 402 and a material of the first semiconductor material layer 401 need to each have a lattice constant that is relatively matched and have different etching selectivities. Specifically:
The constituent material of the first semiconductor material layer 401 may be silicon, and the material of the second semiconductor material layer 402 may be silicon germanium. As a crystal, silicon germanium has a fixed lattice constant and crystal orientation, and the lattice constant and the crystal orientation are relatively matched with those of the subsequently formed stacked silicon, thus being capable of providing a growth surface and a support surface for the epitaxial growth of the subsequently formed stacked silicon. Meanwhile, the etching selectivity of silicon germanium is different from that of silicon, so that the silicon germanium can be easily removed without damaging the silicon, thus facilitating the removal of remaining silicon germanium in the subsequent process.

Next, as shown in FIG. 6, a plurality of first trenches 405 penetrating through the stack and extending along a third direction are formed in the stack structure 400. The first trenches 405 divide remaining stack structure into a first stack wall 403 extending along a second direction and a plurality of second stack walls 404 extending along the third direction.

Here, one layer of remaining first semiconductor material layer in the first stack wall 403 is used to form one bit line, and one layer of remaining first semiconductor material layer in the second stack wall 404 is used to form an active area.

It can be understood that the bit lines here are integrally formed with a structure used to form the active areas.

To clearly describe the present disclosure, the second direction and the third direction are both directions parallel to the surface of the substrate, and the second direction intersects with the third direction, and in some specific embodiments, the second direction is perpendicular to the third direction. Illustratively, the second direction is an X axis direction shown in FIGS. 5-14, and the third direction is a Y axis direction shown in FIGS. 5-14, but it should be noted that the description in the following embodiments with respect to the directions is only for illustrating the present disclosure and is not intended to limit the scope of the present disclosure.

In some specific embodiments, a method of forming the first trench 405 includes, but is not limited to, a dry etching process.

It can be understood that sizes of the second stack walls 404 along the second direction may be the same, and sizes of the first trenches 405 along the first direction may be the same, which can ensure that the parameter performance of the transistors formed in the subsequent process is as consistent as possible.

In some specific embodiments, a method for forming the bit lines using the remaining first semiconductor material layers 401 in the first stack wall 403 may include, but is not limited to, a doping process or a diffusion process.
Illustratively, the remaining first semiconductor material layers 401 in the first stack wall 403 are doped using a diffusion process to reduce a resistivity of the remaining first semiconductor material layers.

In some specific embodiments, the bit line may be formed separately, that is, the bit line and the structure for forming the active area are not integrally formed, and the active area may be formed first and then the bit line may be formed, so that the bit line is connected to one end portion of the active area; alternatively, the bit line is formed first and then the active area is formed, so that one end portion of the active area is connected to the bit line.

Here, the first stack wall 403 and the second stack walls 404 are integrally connected, and bit lines are formed using the remaining first semiconductor material layers 401 in the first stack wall, that is, the bit line and the active areas are formed on the same first semiconductor material layer 401; in other words, the size of each bit line along the first direction is equal to the size of the active area along the first direction. Compared with separately forming the bit line and then connecting the bit line to one end portion of the active area, integrally forming the bit line and the structure for forming the active area can effectively reduce a contact resistance of the bit line and the active area and simplify the manufacturing process.

In some embodiments, forming the active areas includes: doping the remaining first semiconductor material layers 401 in the second stack wall 404. Further, in some specific embodiments, a transistor is formed in the active area, and forming the transistor includes: forming one of a source or a drain at a position close to the first stack wall 403 in the remaining first semiconductor material layer 401 in the second stack wall 404; and forming the remaining one of the source or the drain at a position away from the first stack wall 403 in the remaining first semiconductor material layer 401 in the second stack wall 404.

In some specific embodiments, a method for forming the source and the drain includes, but is not limited to, a doping process, a diffusion process, and the like.

Illustratively, a diffusion process may be used to form an N-type or P-type semiconductor as a source at a position close to the first stack wall 403 in the remaining first semiconductor material layer 401 in the second stack wall 404, and a diffusion process may be used to form an N-type or P-type semiconductor as a drain at a position away from the first stack wall 403 in the remaining first semiconductor material layer 401 in the second stack wall 404.

Next, step S300 and step S400 are performed. In step S300, a plurality of word lines are mainly formed; in step S400, a plurality of memory structures are mainly formed.

It should be noted that the step S300 of mainly forming the word lines and the step S400 of mainly forming the memory structures are not strictly separated, and the forming steps are not performed in sequence. Next, the semiconductor structure will be treated before forming the memory structures.

In some embodiments, the first trench is filled with a support layer; as shown in FIG. 7, the first trench 405 is filled with a support layer 407.
In some specific embodiments, a material of the support layer 407 includes, but is not limited to, silicon oxide (SiO2), silicon nitride (Si3N4), and other low-K materials.

In some specific embodiments, a method for filling the first trench 405 with the support layer 407 includes, but is not limited to, physical vapor deposition (PVD), chemical vapor deposition (CVD), and other processes.

In some specific embodiments, the etching selectivity between any two of the support layer 407, the first semiconductor material layer 401, and the second semiconductor material layer 402 is greater than 10:1.

It can be understood here that the support layer 407 will be removed in a subsequent process and the second semiconductor material layer will also be removed in a subsequent process, and they can be easily removed by etching or other processes if the etching selectivity between any two of the support layer 407, the first semiconductor material layer 401, and the second semiconductor material layer 402 is greater than 10:1.

The position of the first trench 405 here is the position of a shallow trench isolation region in a subsequently manufactured semiconductor structure.

Part of the first insulating layer formed here may serve as a filling material in the shallow trench isolation region to provide isolation for adjacent transistors in a subsequently manufactured semiconductor structure.

Since the bit lines are formed in the first stack wall 403 and the transistors, the word lines, and the memory structures are formed in the second stack walls 404, in order to highlight the manufacturing process of the memory structures, the semiconductor structure in FIG. 7 is divided into two parts; the two parts are separated by a straight line AA', part of the second stack walls 404 away from the first stack wall 403 is part a, and the first stack wall 403 and part of the second stack walls 404 that remain are part b. The division here is not physically cutting apart, but is artificially divided for convenience of description. The part a and the part b are connected in the forming process, and the part a and the part b are simultaneously treated in the forming process.

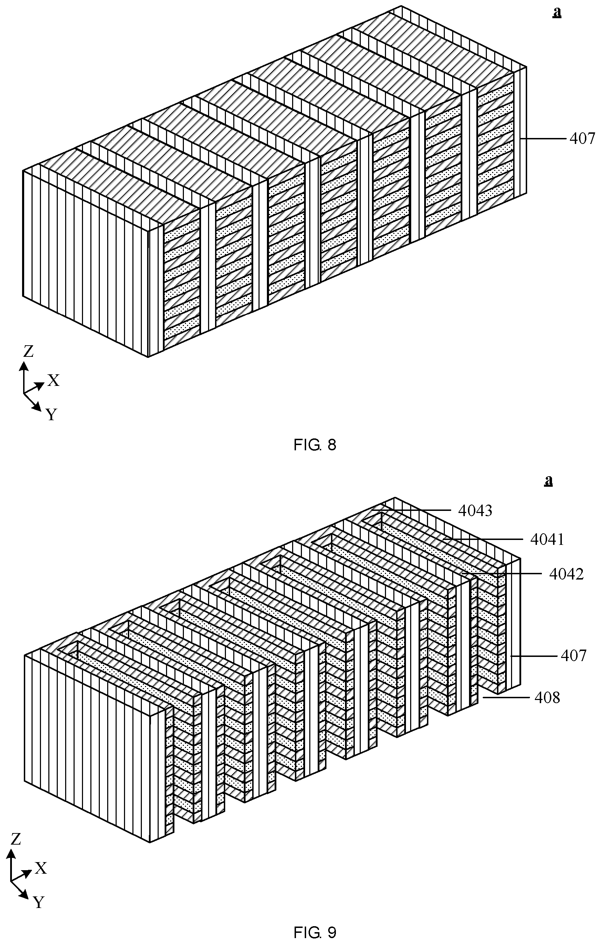

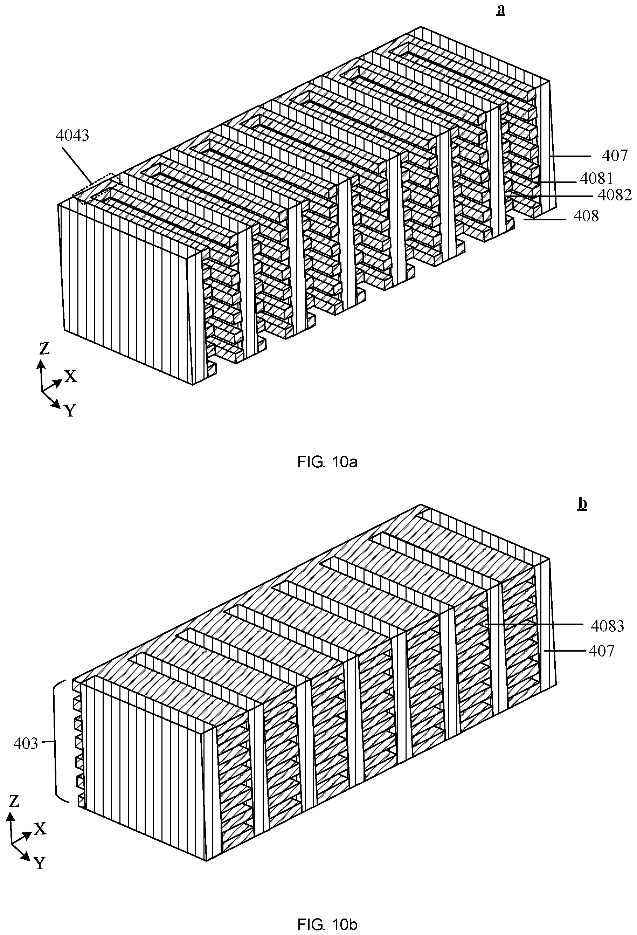

The bit lines and the word lines here are located in the part b, and the transistor is partially located in the part a and partially located in the part b. The memory structures are located in the part a. The present disclosure is primarily directed to the manufacturing process of the part a. FIG. 8 is the part a of FIG. 7; FIGS. 9, 10a, and 11-14 are schematic structural views illustrating the manufacturing process of the semiconductor structure in FIG. 8, i.e., the part a in FIG. 7; FIG. 10b is a schematic structural view illustrating the manufacturing process of the part b in FIG. 7.

Next, as shown in FIG. 9, in some embodiments, the method for forming the active areas further includes:
forming a second trench 408 having an open end face at an end portion of each one of the second stack walls 404 away from the first stack wall 403 along the third direction, where the second trench 408 divides remaining first semiconductor material layers in a part of the second stack wall 404 away from the first stack wall 403 into first parts 4041 and second parts 4042 extending along the third direction and third parts 4043 each connecting one end of the first part 4041 and one end of the second part 4042.

In some specific embodiments, a method for forming the second trench includes, but is not limited to, a dry etching process.

In some embodiments, a size of the first end portion of the active area along the third direction is less than or equal to a size of the second end portion of the active area along the third direction.

It can be understood that the memory structure needs to be formed between the first part 4041 and the second part 4042 at the second end portion of the active area, and when the size of the second end portion of the active area along the third direction is larger, a larger space can be provided for forming the memory structure, and the formed memory structure has a relatively large size, and thus the amount of charge that can be stored is larger.

Next, as shown in FIGS. 10a and 10b, in some embodiments, the remaining second semiconductor material layers are removed through the second trench 408, thus exposing a surface of part of the support layer 407.

In some specific embodiments, a method for removing the remaining second semiconductor material layers includes, but is not limited to, a wet etching process.

It should be noted that the remaining second semiconductor material layer in the first stack wall 403 and the part of the second stack walls 404 close to the first stack wall 403 (i.e., part b in FIG. 7) not shown in FIG. 9 is removed together by wet etching. It can be understood that the manner of removing the second semiconductor material layer here can be directly using the second trench, and no additional process steps are required, thus enabling simple implementation.

Next, before forming the memory structures, the positions where the remaining second semiconductor material layers are removed need to be treated.
In some embodiments, after the remaining second semiconductor material layers are removed, filling with a first insulating layer is performed, and the first insulating layer covering the support layer and surfaces of the remaining first semiconductor material layers is removed to expose surfaces of the remaining first semiconductor material layers and part of the support layer.

It can be understood that when the remaining second semiconductor material layers are removed through the second trench 408 to expose the surface of part of the support layer 407, the remaining second semiconductor material layers in the first stack wall 403 and part of the second stack wall 404 close to the first stack wall 403 in part b shown in FIG. 10b are also removed, and the remaining first semiconductor material layers 401 in the first stack wall 403 and part of the second stack wall 404 close to the first stack wall 403 in part b shown in FIG. 10b are in a suspending state.

If the memory structure is now formed directly, i.e., on the exposed surfaces of the first part 4041, the second part 4042, and the third part 4043 of part a in FIG. 10a, the memory structure may be partially located at positions where the remaining second semiconductor material layer is removed, for example, at the position of a third gap (not shown in FIG. 10a). The third gap here is a gap between two third parts 4043 that are adjacent along the first direction, and the third gap here is in communication with the third gap 4083 in part b of FIG. 10b and the two gaps are part of an integral gap. Subsequent removal of the memory structure at this part is troublesome, and therefore, after the remaining second semiconductor material layer is removed, at least the position of the third gap 4083 should be filled with the first insulating layer before the memory structure is formed, thus avoiding the process of removing part of the memory structure described above.

In some specific embodiments, a method for filling with the first insulating layer includes, but is not limited to, chemical vapor deposition and physical vapor deposition.

In some specific embodiments, a material of the first insulating layer includes, but is not limited to, silicon oxide (SiO2).

It can further be understood that when the first insulating layer is formed after the remaining second semiconductor material layers are removed, the first insulating layer is also formed at the position of the second trench 408, and then the first insulating layer in the second trench 408 needs to be removed to expose the surfaces of the first semiconductor material layers.

In some specific embodiments, a method for removing the first insulating layer includes, but is not limited to, a mask process, and it can be understood that after treatment by the mask process, most of the first insulating layer is removed, but there is still untreated first insulating layer. The untreated first insulating layer includes the first insulating layer at positions of a first gap 4081 and a second gap 4082 of part a in FIG. 10a and the third gap. The first gap 4081 is a gap between two first parts 4041 adjacent along the first direction, the second gap 4082 is a gap between two second parts 4042 adjacent along the first direction, and the third gap is a gap between two third parts 4043 adjacent along the first direction. At this time, the first insulating layer remaining at the positions of the first gap 4081 and the second gap 4082 is removed by a wet etching process, and the support layer 407 may be used as an etching stop layer.
In some embodiments, sizes of the first part 4041 and the second part 4042 along the second direction are less than or equal to a size of the third part 4043 along the third direction.

It can be understood that the wet etching process is an isotropic etching process, and when the first insulating layer remained at the positions of 4081 and 4082 is etched, the first insulating layer between the third parts 4043 arranged along the first direction is also etched. When the size of the first part 4041 and the second part 4042 along the second direction is less than or equal to the size of the third part 4043 along the third direction, the erroneous connection between the bit line and the electrode of the memory structure in the active area due to excessive etching of the first insulating layer can be prevented.

Next, memory structures are formed on exposed surfaces of the first semiconductor material layers. In some embodiments, a method for forming memory structures includes:
forming an electrode material layer, where the electrode material layer covers exposed surfaces of the first parts, the second parts, and the third parts, and a surface of an exposed part of the support layer;
forming a dielectric layer covering a surface of the electrode material layer;
forming a second electrode covering a surface of the dielectric layer;
removing the support layer;
removing at least part of the first insulating layer close to the electrode material layer; and
removing exposed electrode material layer and forming first electrodes using remaining electrode material layer.

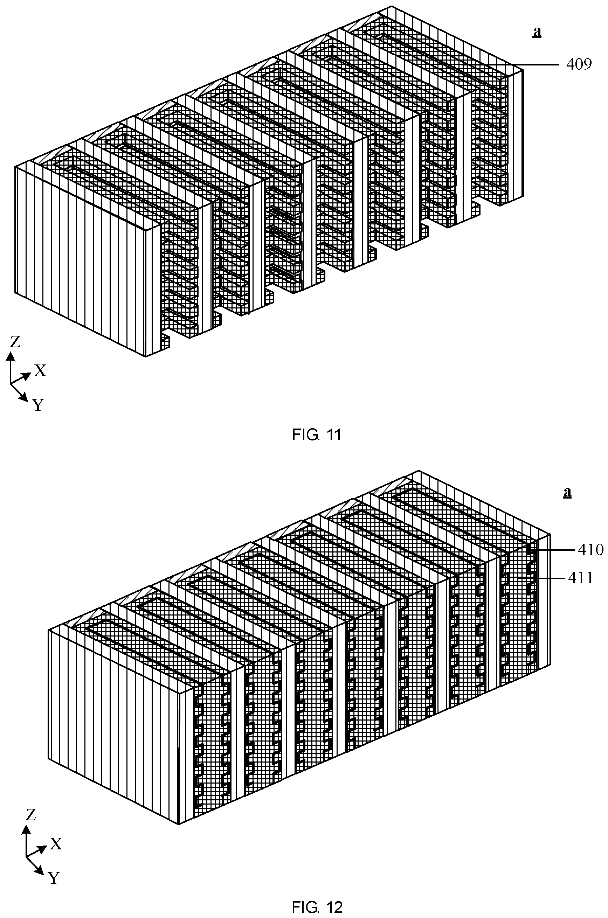

The formation of the memory structure will be described in detail below with reference to FIGS. 11-14.

As shown in FIG. 11, an electrode material layer 409 is formed. The electrode material layer 409 covers exposed surfaces of the first parts 4041, the second parts 4042, and the third parts 4043, and a surface of an exposed part of the support layer 407.

In some specific embodiments, a method for forming the electrode material layer 409 includes, but is not limited to, atomic layer deposition.

In some specific embodiments, a material of the electrode material layer 409 includes, but is not limited to, titanium nitride (TiN).

Illustratively, a layer of titanium nitride is deposited on the exposed surfaces of the first parts 4041, the second parts 4042, and the third parts 4043, and the surface of the exposed part of the support layer 407 through atomic layer deposition. It can be understood that the gas required by the atomic layer deposition process enters the exposed surfaces of the first parts 4041, the second parts 4042, and the third parts 4043, and the surface of the exposed part of the support layer 407 through the opening formed after the first insulating layer is removed, which, compared with the closed trenches in the related art, increases the cross-sectional area of the gas inlet/outlet channel, quickens the deposition, and reduces the difficulty of the deposition process.

As shown in FIG. 12, a dielectric layer 410 covering a surface of the electrode material layer 409 is formed;
a second electrode 411 covering a surface of the dielectric layer 410 is formed.

In some specific embodiments, a method for forming the dielectric layer 410 includes, but is not limited to, atomic layer deposition.

In some specific embodiments, a constituent material of the dielectric layer includes a high-K material, which generally refers to a material having a dielectric constant greater than 3.9 and typically significantly greater than that value.

In some specific embodiments, a material of the dielectric layer may include, but is not limited to, aluminum oxide (AI2O3), zirconium oxide (ZrO), hafnium oxide (HfO2), strontium titanate (SrTiO3), and the like.

In some specific embodiments, a method for forming the second electrode 411 includes, but is not limited to, atomic layer deposition, chemical vapor deposition, and physical vapor deposition.

In some specific embodiments, a constituent material of the second electrode 411 may include, but is not limited to, ruthenium (Ru), ruthenium oxide (RuO2), and titanium nitride (TiN).

In some embodiments, before forming the electrode material layer 409, a metal layer is formed, where the metal layer covers at least the exposed surfaces of the first parts 4041, the second parts 4042, and the third parts 4043;
an annealing process is used to react the metal layer with the first parts 4041, the second parts 4042, and the third parts 4043 to form a connection structure.

In some specific embodiments, a method for forming the metal layer includes, but is not limited to, chemical vapor deposition, physical vapor deposition, atomic layer deposition, and the like.

In some specific embodiments, a constituent material of the metal layer includes, but is not limited to, cobalt (Co), nickel (Ni), zinc (Zn), silver (Ag), and titanium (Ti).

In some specific embodiments, the annealing process used includes, but is not limited to, a rapid thermal process (RTP).

It can be understood that the metal layer covering the first parts 4041, the second parts 4042 and the third parts 4043 and the semiconductor material of the first parts 4041, the second parts 4042 and the third parts 4043 can form a metal-semiconductor compound after treatment with the rapid thermal process, and the metal-semiconductor compound can effectively reduce a contact resistance between the memory structure and the active area in the subsequent process.

At this time, the electrode material layer 409, the dielectric layer 410, and the second electrode 411 are continuous in a plane where the first direction and the third direction are located, that is, a plane where the Y axis and the Z axis are located.

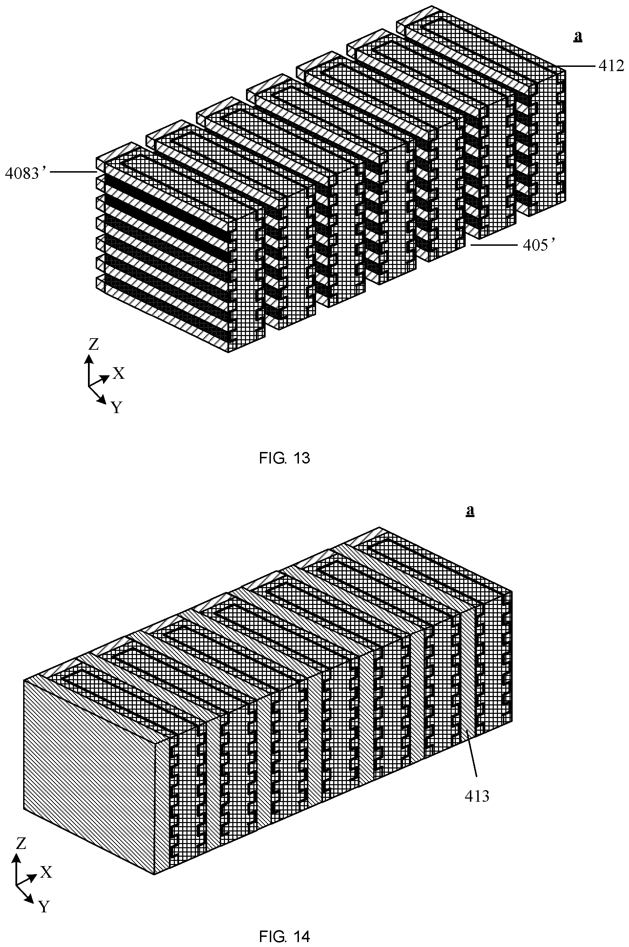

Next, the electrode material layer 409 needs to be divided into first electrodes 412 covering second end portions of all active areas.
As shown in FIG. 13, the support layer is removed, and in some specific embodiments, a method for removing the support layer includes, but is not limited to, a dry etching process.

It can be understood that after the support layer is removed, part of the surface of each of the first parts 4041, the second parts 4042, the electrode material layer 409, and the first insulating layer is exposed, and at this time, after the support layer is removed, trenches 405' are formed in the semiconductor structure. Part of the first insulating layer close to the electrode material layer or all the first insulating layer is removed through the trenches 405' to form fourth gaps 4083', and the fourth gaps 4083' may continue to expose part of the surface of the electrode material layer 409.

Here, removing all the first insulating layer facilitates the introduction of gas or liquid for etching the electrode material layer.

Next, the exposed electrode material layer 409 is removed through the fourth gaps 4083' and the trenches 405', and the remaining electrode material layer is divided into individual first electrodes 412.

In some specific embodiments, a method for removing part of the first insulating layer includes, but is not limited to, wet etching, and here, the electrode material layer 409 may be used as an etching stop layer.

In some specific embodiments, a method for removing the exposed electrode material layer 409 includes, but is not limited to, wet etching, and here, the dielectric layer 410 may be used as an etching stop layer.

Next, as shown in FIG. 14, after the exposed electrode material layer is removed, filling with a second insulating layer 413 is performed at positions where the support layer, part of the first insulating layer, and the exposed electrode material layer are removed.

In some specific embodiments, a method for filling with the second insulating layer 413 includes, but is not limited to, physical vapor deposition and chemical vapor deposition.

In some specific embodiments, a material of the second insulating layer 413 includes, but is not limited to, silicon oxide.

It can be understood that the second insulating layer 413 is used as part of the isolation layer between two adjacent columns of active areas along the second direction, so that the electrical crosstalk between the two columns of active areas can be effectively prevented.

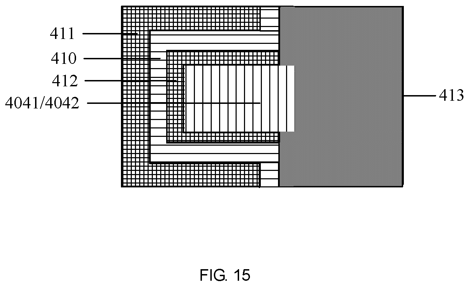

FIG. 15 is a cross-sectional view of a memory structure of a semiconductor structure provided according to an embodiment of the present disclosure. In the figure, a second insulating layer 413, a first part 4041 (or a second part 4042) located on one side of the second insulating layer 413, a first electrode 412 covering the first part 4041, a dielectric layer 410 covering the first electrode 412, and a second electrode 411 covering the dielectric layer 410 are shown.

Here, the formed memory structure is located between a first part and a second part of a second end portion of each active area. Each active area includes a first end portion and a second end portion oppositely arranged along a third direction, the second end portion has a first part and a second part extending along the third direction and a third part connecting one end of the first part and one end of the second part, the third part is located at one end close to the first end portion, and the other end of the first part and the other end of the second part are separated from each other, so that the second end portion of the active area has an opening structure. Compared with the traditional closed trench structure formed in the active area, the process of forming an opening structure in the active area is simpler; meanwhile, the opening structure provides a larger area and a smoother gas inlet/outlet channel for the subsequent process steps, such as atomic layer deposition, which reduces the process difficulty of the subsequent process.

The second insulating layer here has the function of isolating two adjacent columns of memory cells arranged along the X axis direction, where the memory cell here includes an active area and a memory structure connected to the active area.

In addition to forming the memory structures, it is also necessary to form word lines.

In some embodiments, a method for forming the word lines includes:
forming a third trench penetrating through the second stack wall at a position close to the first stack wall, where sidewalls of the third trench all expose part of the first semiconductor material layers; and
forming the word line in the third trench.

It can be understood that the third trenches are located at part b in FIG. 7.
Here, each word line is connected to a position between the first end portion and the second end portion of each one of a plurality of active areas in the same column, and the plurality of active areas cover two sidewalls of the word line opposite to each other along the second direction and two sidewalls of the word line opposite to each other along the third direction, thus forming a channel-all-around word line.

In other embodiments, a gate-all-around word line may also be formed.

In other specific embodiments, the word line is located on one side of the active area, i.e., a single gate structure.

In other specific embodiments, the word lines include a first word line and a second word line, and the first word line and the second word line are respectively located on opposite sides of the active area along the second direction, i.e., a double gate structure.

It can be understood that when the channel-all-around word line is matched with the memory structure with an opening structure here, the volume of the memory structure is relatively large, and the amount of stored charges is larger. Meanwhile, the size of the active area along the second direction enables to provide enough space for forming a channel-all-around word line.
After comparison of the two, whether the single gate structure in which the word line is located on one side of the active area or the double gate structure in which the word line is located on two sides of the active area is selected, the word line needs to utilize the space of the isolation layer between the active areas arranged along the second direction, and thus the size of the isolation layer along the second direction is inevitably increased, so that the size of the semiconductor structure along the second direction is increased. In some specific embodiments, a method for forming the third trench includes, but is not limited to, a dry etching process.

In some specific embodiments, a method for forming the word line includes, but is not limited to, physical vapor deposition and chemical vapor deposition.
In some specific embodiments, a material of the word line includes a metal, such as copper (Cu), cobalt (Co), tungsten (W), molybdenum (Mo), and the like.

It should be noted that after the second stack walls 404 are formed, the word lines can be formed. In some embodiments, a gate dielectric layer is formed on the exposed part of the sidewalls of the second stack walls before the word lines are formed in the third trenches.

In some specific embodiments, a material composition of the gate dielectric layer includes, but is not limited to, silicon oxide (SiO2), hafnium oxide (HfO2), aluminum oxide (AI2O3), and the like.

In some specific embodiments, a method for forming the gate dielectric layer includes, but is not limited to, chemical vapor deposition, physical vapor deposition, atomic layer deposition, and the like.

According to another aspect of the present disclosure, an embodiment of the present disclosure further provides a semiconductor structure, which includes:
a plurality of active areas forming an array having a plurality of layers arranged along a first direction and a plurality of columns arranged along a second direction, where each one of the plurality of active areas has a first end portion and a second end portion opposite to each other along a third direction; the second end portion has a first part and a second part extending along the third direction and a third part connecting one end of the first part and one end of the second part, and the third part is located at one end close to the first end portion; the other end of the first part and the other end of the second part are separated from each other; every two of the first direction, the second direction, and the third direction intersect with each other;
   a plurality of bit lines stacked along the first direction, each one of the plurality of bit lines extending along the second direction and being connected to the first end portions of a plurality of active areas in the same layer;
a plurality of word lines, each one of the plurality of word lines extending along the first direction and being connected to a plurality of active areas in the same column; and
   a plurality of memory structures, each one of the plurality of memory structures covering part of a surface of the second end portion and filling a gap between the first part and the second part.

In some embodiments, the plurality of memory structures include a plurality of first electrodes, a dielectric layer, and a second electrode.

The first electrode covers part of surfaces of the first part, the second part, and the third part of the second end portion of the active area;
the second electrode is located between the first parts and the second parts of a plurality of active areas in the same column and between the second end portions of two active areas adjacent along the first direction;
the dielectric layer is located between the plurality of first electrodes and the second electrode, and the dielectric layer and the second electrode are shared by a plurality of memory structures in the same column.

In some embodiments, sizes of the first part and the second part along the second direction are less than or equal to a size of the third part along the third direction.

In some embodiments, a size of the first end portion of the active area along the third direction is less than or equal to a size of the second end portion of the active area along the third direction.

In some embodiments, the first part, the second part, and the third part of the second end portion include a metal-semiconductor compound.

In some embodiments, the semiconductor structure further includes a plurality of isolation layers; each one of the plurality of isolation layers is located between two adjacent columns of active areas along the second direction.

In some embodiments, each word line is connected to a position between the first end portion and the second end portion of each one of a plurality of active areas in the same column, and the plurality of active areas cover two sidewalls of the word line opposite to each other along the second direction and two sidewalls of the word line opposite to each other along the third direction.

In some embodiments, a size of each bit line along the first direction is equal to a size of the active area along the first direction.

In some embodiments, the bit lines are integrally formed with a structure used to form the active areas.

According to another aspect of the present disclosure, provided is a memory, which includes one or more semiconductor structures as described in any one of the above embodiments of the present disclosure.

Based on this, the active area in the semiconductor structure provided in the embodiments of the present disclosure includes a first end portion and a second end portion oppositely arranged along a third direction, and the second end portion has a first part and a second part extending along the third direction and a third part connecting the first part and the second part, so that the second end portion of the active area has an opening structure. Compared with the traditional closed trench structure formed in the active area, the process of forming a groove with an opening structure on one side in the active area is simpler; meanwhile, the opening structure can provide a larger area and a smoother gas inlet/outlet channel for the subsequent process steps, such as atomic layer deposition, which reduces the process difficulty of the subsequent process.

It should be understood that reference throughout this specification to "one embodiment" or "an embodiment" means that a particular feature, structure, or characteristic described in connection with the embodiment is included in at least one embodiment of the present disclosure. Therefore, the appearances of the phrases "in one embodiment" or "in an embodiment" in various places throughout this specification do not necessarily all refer to the same embodiment. Furthermore, these particular features, structures, or characteristics may be combined in any suitable manner in one or more embodiments. It should be understood that, in various embodiments of the present disclosure, the sequence numbers of the processes described above do not imply an order of execution, and the order of execution of the processes should be determined by their functions and inherent logic, and these sequence numbers should not constitute any limitation to the implementation process of the embodiments of the present disclosure. The serial numbers of the embodiments of the present disclosure described above are for the purpose of describing only and do not represent the superiority or inferiority of the embodiments.

The methods disclosed in the method embodiments provided in the present disclosure may be combined in any manner if without conflict to obtain new method embodiments.

The above description is only the specific embodiments of the present disclosure, but the scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

### Industrial Applicability

Embodiments of the present disclosure provide a semiconductor structure and a method for manufacturing the same. The active area in the semiconductor structure provided in the embodiments of the present disclosure includes a first end portion and a second end portion oppositely arranged along a third direction, the second end portion has a first part and a second part extending along the third direction and a third part connecting one end of the first part and one end of the second part, the third part is located at one end close to the first end portion, and the other end of the first part and the other end of the second part are separated from each other, so that the second end portion of the active area is in an opening structure. Compared with the traditional closed trench structure formed in the active area, the process of forming a trench with an opening structure on one side in the active area is simpler; meanwhile, the opening structure can provide a larger area and a smoother gas inlet/outlet channel for the subsequent process steps, such as atomic layer deposition (ALD), which reduces the process difficulty of the subsequent process.

## Claims

1. A semiconductor structure, comprising:
a plurality of active areas forming an array having a plurality of layers arranged along a first direction and a plurality of columns arranged along a second direction, wherein each one of the plurality of active areas has a first end portion and a second end portion opposite to each other along a third direction; the second end portion has a first part (4041) and a second part (4042) extending along the third direction and a third part (4043) connecting one end of the first part (4041) and one end of the second part (4042), and the third part (4043) is located at one end close to the first end portion; the other end of the first part (4041) and the other end of the second part (4042) are separated from each other; every two of the first direction, the second direction, and the third direction intersect with each other;
a plurality of bit lines stacked along the first direction, each one of the plurality of bit lines extending along the second direction and being connected to the first end portions of a plurality of active areas in the same layer;
a plurality of word lines, each one of the plurality of word lines extending along the first direction and being connected to a plurality of active areas in the same column; and
a plurality of memory structures, each one of the plurality of memory structures covering part of a surface of the second end portion and filling a gap between the first part (4041) and the second part (4042).

2. The semiconductor structure according to claim 1, wherein the plurality of memory structures comprise: a plurality of first electrodes (412), a dielectric layer (410), and a second electrode (411);
each one of the plurality of first electrodes (412) covers part of surfaces of the first part (4041), the second part (4042), and the third part (4043) of the second end portion of the active area;
the second electrode (411) is located between the first parts (4041) and the second parts (4042) of a plurality of active areas in the same column and between the second end portions of two active areas adjacent along the first direction;
the dielectric layer (410) is located between the plurality of first electrodes (412) and the second electrode (411), and the dielectric layer (410) and the second electrode (411) are shared by a plurality of memory structures in the same column.

3. The semiconductor structure according to claim 1 or 2, wherein sizes of the first part (4041) and the second part (4042) along the second direction are less than or equal to a size of the third part (4043) along the third direction.

4. The semiconductor structure according to any one of claims 1-3, wherein a size of the first end portion of the active area along the third direction is less than or equal to a size of the second end portion of the active area along the third direction.

5. The semiconductor structure according to any one of claims 1-4, wherein the first part (4041), the second part (4042), and the third part (4043) of the second end portion comprise a metal-semiconductor compound.

6. The semiconductor structure according to any one of claims 1-5, further comprising a plurality of isolation layers, wherein each one of the plurality of isolation layers is located between two adjacent columns of active areas along the second direction.

7. The semiconductor structure according to any one of claims 1-6, wherein each one of the plurality of word lines is connected to a position between the first end portion and the second end portion of each one of a plurality of active areas in the same column, and the plurality of active areas cover two sidewalls of the word line opposite to each other along the second direction and two sidewalls of the word line opposite to each other along the third direction.

8. The semiconductor structure according to any one of claims 1-7, wherein a size of each one of the plurality of bit lines along the first direction is equal to a size of the active area along the first direction.

9. The semiconductor structure according to any one of claims 1-8, wherein the bit lines are integrally formed with a structure used to form the active areas.

10. A method for manufacturing a semiconductor structure, comprising:
forming a plurality of active areas, wherein the plurality of active areas form an array having a plurality of layers arranged along a first direction and a plurality of columns arranged along a second direction; each one of the plurality of active areas has a first end portion and a second end portion opposite to each other along a third direction; a first part (4041) and a second part (4042) extending along the third direction and a third part (4043) connecting one end of the first part (4041) and one end of the second part (4042) are formed at the second end portion, and the third part (4043) is located at one end close to the first end portion; the other end of the first part (4041) and the other end of the second part (4042) are separated from each other; every two of the first direction, the second direction, and the third direction intersect with each other; forming a plurality of bit lines, wherein the plurality of bit lines are stacked along the first direction, and each one of the plurality of bit lines extends along the second direction and is connected to the first end portions of a plurality of active areas in the same layer;
forming a plurality of word lines, wherein each one of the plurality of word lines extends along the first direction and is connected to a plurality of active areas in the same column; and
forming a plurality of memory structures, wherein each one of the plurality of memory structures covers part of a surface of the second end portion and fills a gap between the first part (4041) and the second part (4042).

11. The method for manufacturing a semiconductor structure according to claim 10, wherein a method for forming the bit lines and the active areas comprises:
forming a stack structure (400) along the first direction, wherein the stack structure (400) comprises a plurality of alternately stacked first semiconductor material layers (401) and second semiconductor material layers (402); and
forming a plurality of first trenches (405) penetrating through the stack structure (400) and extending along the third direction in the stack structure (400), wherein the plurality of first trenches (405) divide remaining stack structure (400) into a first stack wall (403) extending along the second direction and a plurality of second stack walls (404) extending along the third direction.

12. The method for manufacturing a semiconductor structure according to claim 11, further comprising:
filling the first trenches (405) with a support layer (407), wherein
the method for forming the active areas further comprises:
forming a second trench (408) having an open end face at an end portion of each one of the plurality of second stack walls (404) away from the first stack wall (403) along the third direction, wherein the second trench (408) divides remaining first semiconductor material layers (401) in a part of the second stack wall (404) away from the first stack wall (403) into first parts (4041) and second parts (4042) extending along the third direction and third parts (4043) each connecting one end of the first part (4041) and one end of the second part (4042).

13. The method for manufacturing a semiconductor structure according to claim 12, wherein an etching selectivity between any two of the support layer (407), the first semiconductor material layer (401), and the second semiconductor material layer (402) is greater than 10:1.

14. The method for manufacturing a semiconductor structure according to claim 12 or 13, comprising:
removing remaining second semiconductor material layers (402) through the second trench (408) to expose a surface of part of the support layer (407).

15. The method for manufacturing a semiconductor structure according to claim 14, comprising:
filling with a first insulating layer after the remaining second semiconductor material layers (402) are removed; and removing the first insulating layer covering the support layer (407) and surfaces of remaining first semiconductor material layers (401) to expose the surfaces of the remaining first semiconductor material layers (401) and the surface of part of the support layer (407).

16. The method for manufacturing a semiconductor structure according to claim 15, wherein a method for forming the plurality of memory structures comprises:
forming an electrode material layer (409), wherein the electrode material layer (409) covers exposed surfaces of the first parts (4041), the second parts (4042), and the third parts (4043), and a surface of an exposed part of the support layer (407);
forming a dielectric layer (410) covering a surface of the electrode material layer (409);
forming a second electrode (411) covering a surface of the dielectric layer (410);
removing the support layer (407);
removing at least part of the first insulating layer close to the electrode material layer (409); and
removing exposed electrode material layer (409) and forming first electrodes (412) using remaining electrode material layer (409).

17. The method for manufacturing a semiconductor structure according to claim 16, comprising:
after the electrode material layer (409) covering the support layer (407) is removed, filling with a second insulating layer (413) at positions where the support layer (407) and the electrode material layer (409) are removed.

18. The method for manufacturing a semiconductor structure according to any one of claims 12-17, wherein forming the word lines comprises:
forming a third trench penetrating through the second stack wall (404) at a position close to the first stack wall (403), wherein sidewalls of the third trench all expose part of the first semiconductor material layers (401); and
forming the word line in the third trench.
